# EUROPEAN PATENT APPLICATION

(11) **EP 4 752 616 A1**
(43) Date of publication of application: **03.06.2026**
(21) Application number: 25163718.7
(22) Date of filing: 14.03.2025
(51) Int. Cl.: G02B 6/42, H05K 5/02, H05K 7/20

(54) **OPTICAL TRANSCEIVER MODULE SOCKET CAGE, OPTICAL TRANSCEIVER MODULE, AND OPTICAL TRANSCEIVER MODULE SET**

(30) Priority: 28.11.2024 US 202463726252 P; 17.01.2025 TW 114101933
(71) Applicant: All Best Precision Technology Co., Ltd., Taoyuan City 325 (TW)
(72) Inventor: Yang, Haven, 325 Taoyuan City (TW); Yang, Hung-Jhe, 325 Taoyuan City (TW)
(74) Representative: Straus, Alexander

(57) **Abstract**

An optical transceiver module socket cage (142) includes a cage body (1422) and a liquid cooling component (1424) fixedly disposed in the cage body (1422) and exposed in a module-receiving slot (1422a) formed by the cage body (1422). The liquid cooling component (1424) has a flow channel structure (1424c) for a working fluid to flow through to dissipate heat. An optical transceiver module (12) can be inserted into the module-receiving slot (1422a) such that an edge connector (124) of the optical transceiver module (12) is inserted into a connector socket (144) disposed in the module-receiving slot (1422a) and a module housing (122) of the optical transceiver module (12) directly contacts the liquid cooling component (1424) in the module-receiving slot (1422a). Heat generated by the optical transceiver module (12) during operation can be transferred to the liquid cooling component (1424).

## Description

### Field of the Invention

The invention relates to an optical transceiver module socket cage, an optical transceiver module, and an optical transceiver module set according to the pre-characterizing clause of claims 1, 16 and 17 respectively.

### Background of the Invention

In the field of optical communications, the transmission rate of optical transceiver modules continues to increase, and the power of optical transceiver modules during operation also increases, causing the optical transceiver modules to often operate at higher temperatures. Currently, in order to prevent the operating temperature from being too high, heat dissipation fins are provided on the module housing of an optical transceiver module or on the outer casing of an optical transceiver module socket to effectively dissipate generated inside the optical transceiver module during operation. However, the heat dissipation fins alone are gradually unable to meet the usage scenarios with continuously increasing transmission rates, resulting in design bottlenecks in optical transceiver modules or optical transceiver module sockets.

### Summary of the Invention

This in mind, the present invention aims at providing an optical transceiver module socket cage, which uses a liquid cooling component to contact an optical transceiver module inserted into the optical transceiver module socket cage for enhancing heat dissipation efficiency, an optical transceiver module, which is used for being inserted into the optical transceiver module socket cage, and an optical transceiver module set having the optical transceiver module socket cage.

This is achieved by an optical transceiver module socket cage, an optical transceiver module, and an optical transceiver module set according to claims 1, 16 and 17. The dependent claims pertain to corresponding further developments and improvements.

As will be seen more clearly from the detailed description following below, according to an embodiment, an optical transceiver module socket cage includes a cage body and a liquid cooling component. The cage body forms a module-receiving slot. The liquid cooling component has a flow channel structure and an inlet and an outlet which are connected to the flow channel structure. The liquid cooling component is fixedly disposed in the cage body and is exposed in the module-receiving slot. Thereby, when an optical transceiver module is inserted into the module-receiving slot, the liquid cooling component can contact the optical transceiver module to absorb heat generated by the optical transceiver module during operation, thereby achieving the effect of heat dissipation.

According to another embodiment, an optical transceiver module includes a module housing and an edge connector. The module housing has a length direction. The module housing includes a main housing and two vertical plates. The main housing has a flat heat-conducting surface. The two vertical plates protrude from the flat heat-conducting surface. The two vertical plates extend parallel to the length direction and are located on opposite sides of the main housing. A structure-less space is formed between the two vertical plates and the flat heat-conducting surface. The edge connector is exposed on a side of the module housing in the length direction. Thereby, when the optical transceiver module is inserted into an optical transceiver module socket, the flat heat-conducting surface of the optical transceiver module is thermally coupled to a heat exchanger of the optical transceiver module socket, so that the optical transceiver module can transfer the heat generated during operation to the heat exchanger through the flat heat-conducting surface, thereby achieving the effect of heat dissipation.

According to another embodiment, an optical transceiver module set of an embodiment according to the invention includes an optical transceiver module socket and an optical transceiver module. The optical transceiver module socket includes a connector socket and the optical transceiver module socket cage mentioned above. The connector socket is disposed in the module-receiving slot. The optical transceiver module includes a module housing and an edge connector. The module housing includes a main housing having a flat heat-conducting surface. Therein, the optical transceiver module is inserted into the module-receiving slot, so that the edge connector is inserted into the connector socket and the flat heat-conducting surface contacts the liquid cooling component in the module-receiving slot. Thereby, heat generated by the optical transceiver module during operation can be transferred to the liquid cooling component through the flat heat-conducting surface, thereby achieving the effect of heat dissipation for the optical transceiver module.

### Brief Description of the Drawings

**In** the following, the invention is further illustrated by way of example, taking reference to the accompanying drawings. Thereof:
FIG. 1 is a schematic diagram illustrating an optical transceiver module set according to a first embodiment.
FIG. 2 is a partially-exploded view of an optical transceiver module socket in FIG. 1.
FIG. 3 is a schematic diagram illustrating the optical transceiver module socket in FIG. 2 in another viewpoint.
FIG. 4 is an exploded view of a liquid cooling component of an optical transceiver module socket cage in FIG. 2.
FIG. 5 is a top view of a base of the liquid cooling component in FIG. 4.
FIG. 6 is a schematic diagram illustrating a cage body of the optical transceiver module socket cage in FIG. 2 in another viewpoint.
FIG. 7 is a schematic diagram illustrating the cage body in FIG. 6 in another viewpoint.
FIG. 8 is a schematic diagram illustrating the liquid cooling component is to be combined with the cage body.
FIG. 9 is a schematic diagram illustrating the liquid cooling component in FIG. 8 after being combined with the cage body.
FIG. 10 is a schematic diagram illustrating the liquid cooling component is to be combined with the cage body in another view.
FIG. 11 is a schematic diagram illustrating the liquid cooling component in FIG. 10 after being combined with the cage body.
FIG. 12 is a schematic diagram illustrating the liquid cooling component of the optical transceiver module set in FIG. 1 is installed by rotating 180 degrees.
FIG. 13 is a schematic diagram illustrating the liquid cooling component in FIG. 12 is to be combined with the cage body.
FIG. 14 is a schematic diagram illustrating the liquid cooling component in FIG. 13 after being combined with the cage body.
FIG. 15 is a schematic diagram illustrating the liquid cooling component in FIG. 12 is to be combined with the cage body in another view.
FIG. 16 is a schematic diagram illustrating the liquid cooling component in FIG. 15 after being combined with the cage body.
FIG. 17 is a schematic diagram illustrating an optical transceiver module socket according to a second embodiment.
FIG. 18 is a schematic diagram illustrating an optical transceiver module socket according to a third embodiment.
FIG. 19 is a schematic diagram illustrating the optical transceiver module socket in FIG. 18 in another viewpoint.
FIG. 20 is a schematic diagram illustrating an optical transceiver module set according to a fourth embodiment.
FIG. 21 is a partially-exploded view of an optical transceiver module socket in FIG. 20.
FIG. 22 is a schematic diagram illustrating the optical transceiver module socket in FIG. 21 in another viewpoint.
FIG. 23 is an exploded view of a liquid cooling component of an optical transceiver module socket cage in FIG. 21.
FIG. 24 is a schematic diagram illustrating an optical transceiver module socket according to a fifth embodiment.
FIG. 25 is a partially-exploded view of an optical transceiver module socket in FIG. 24.
FIG. 26 is a schematic diagram illustrating a liquid cooling component in FIG. 25 in another viewpoint.
FIG. 27 is an exploded view of the liquid cooling component in FIG. 25.
FIG. 28 is a top view of a base of the liquid cooling component in FIG. 27.
FIG. 29 is a schematic diagram illustrating an optical transceiver module socket according to a sixth embodiment.
FIG. 30 is a partially-exploded view of an optical transceiver module socket in FIG. 29.
FIG. 31 is a partially-exploded view of an optical transceiver module socket according to a seventh embodiment.

### Detailed Description

Directional terms mentioned in the following embodiments, such as up, down, left, right, front or back, etc., are only for reference to the directions in the attached drawings. The prefixes of component names, such as first, second, ..., etc., are only used to distinguish components and facilitate description, and do not impose other restrictions on the components themselves; furthermore, components with the same prefix in various embodiments do not necessarily correspond. The correspondence of components in each embodiment should still depend on the specific structure described in each embodiment.

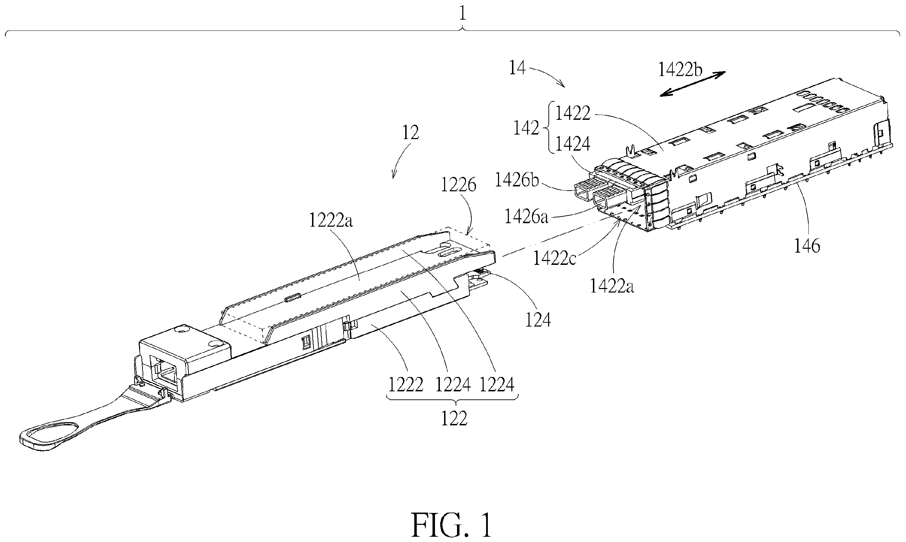

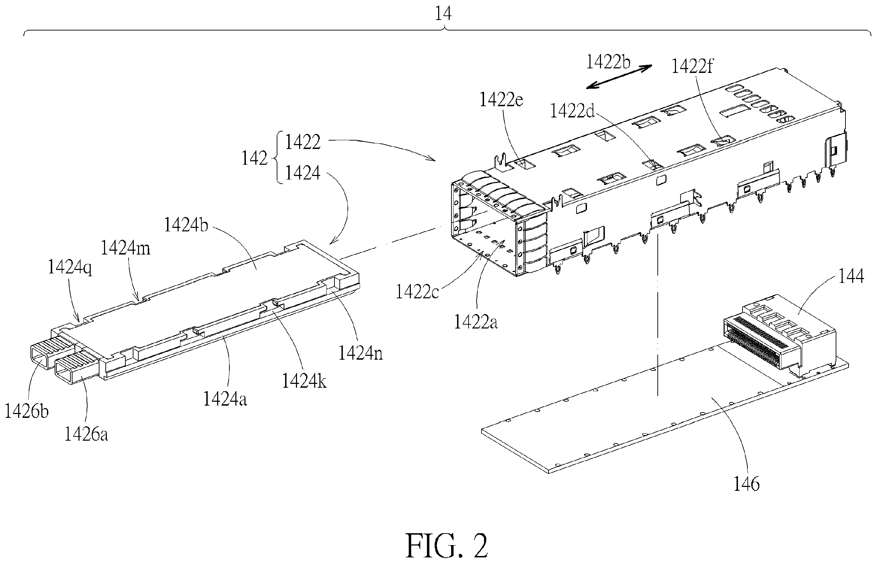

Please refer to FIG. 1 to FIG. 3. An optical transceiver module set 1 according to a first embodiment includes an optical transceiver module 12 and an optical transceiver module socket 14. The optical transceiver module socket 14 includes an optical transceiver module socket cage 142, a connector socket 144, and a circuit board 146. The optical transceiver module socket cage 142 includes a cage body 1422 and a liquid cooling component 1424. The cage body 1422 forms a module-receiving slot 1422a which has a length direction 1422b (indicated by a doubled-headed arrow in the figures) and an insertion opening 1422c in the length direction 1422b. The liquid cooling component 1424 is fixedly disposed in the cage body 1422 and exposed in the module-receiving slot 1422a. The connector socket 144 is electrically fixed on the circuit board 146. The cage body 1422 is fixed on the circuit board 146, so that the connector socket 144 is located in the module-receiving slot 1422a. The optical transceiver module 12 can be inserted into the module-receiving slot 1422a from the insertion opening 1422c parallel to the length direction 1422b to engage with the connector socket 144 and contact the liquid cooling component 1424. Thereby, heat generated by the optical transceiver module 12 during operation can be transferred to the liquid cooling component 1424 (equivalent to a heat exchanger) to achieve a heat dissipation effect.

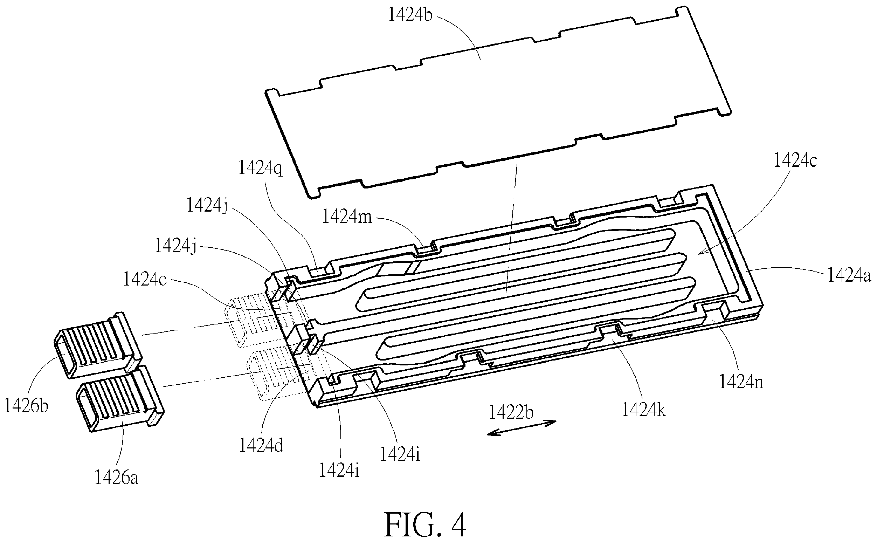

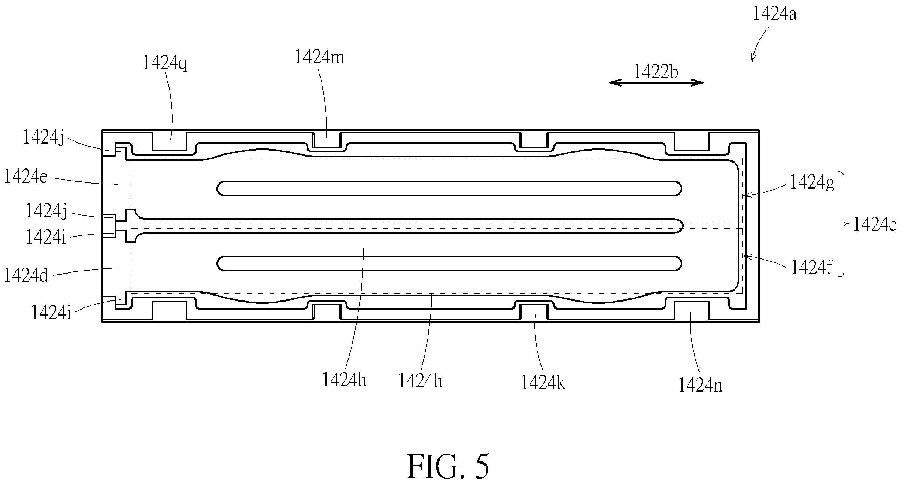

Please refer to FIG. 4 and FIG. 5. The liquid cooling component 1424 includes a base 1424a and a top cover 1424b. The base 1424a forms a flow channel structure 1424c and an inlet 1424d and an outlet 1424e which are connected to the flow channel structure 1424c. The top cover 1424b is fixed on the base 1424a (for example, but limited to tight fitting and/or soldering) to cover the flow channel structure 1424c. A working fluid (not shown in the figures) will flow through the flow channel structure 1424c through the inlet 1424d and the outlet 1424e to remove the heat absorbed by the base 1424a. The flow channel structure 1424c includes a first flow channel portion 1424f and a second flow channel portion 1424g (both are indicated by dashed blocks in the figure), both of which extend parallel to the length direction 1422b. The inlet 1424d, the first flow channel portion 1424f, the second flow channel portion 1424g, and the outlet 1424e are connected in sequence. Furthermore, the first flow channel portion 1424f includes two sub-flow channels 1424h extending parallel to the length direction 1422b. The second flow channel portion 1424g is the same, which will not be repeated in addition. This structural configuration helps the working fluid to flow smoothly through the flow channel structure 1424c, thereby suppressing the generation of local hot spots in the liquid cooling plate 1424.

Furthermore, the optical transceiver module socket cage 142 also includes two transfer tubes 1426a and 1426b, which are fixedly connected to the inlet 1424d and the outlet 1424e respectively, which facilitates connection with the manifold of the external cooling system. For example, a device with the optical transceiver module socket 14 is installed in a cabinet equipped with a cooling system. The manifold of the cooling system is fixed on the bracket of the cabinet and connected to the transfer tubes 1426a and 1426b (for example, hoses connected to the manifold are sleeved on the transfer tube 1426a, 1426b). In the first embodiment, two grooves 1424i are formed on inner side walls of the outlet 1424d. The corresponding transfer tube 1426a tightly fits in the two grooves 1424i. Similarly, two grooves 1424j are formed on inner side walls of the outlet 1424e. The corresponding transfer tube 1426b tightly fits in the two grooves 1424j.

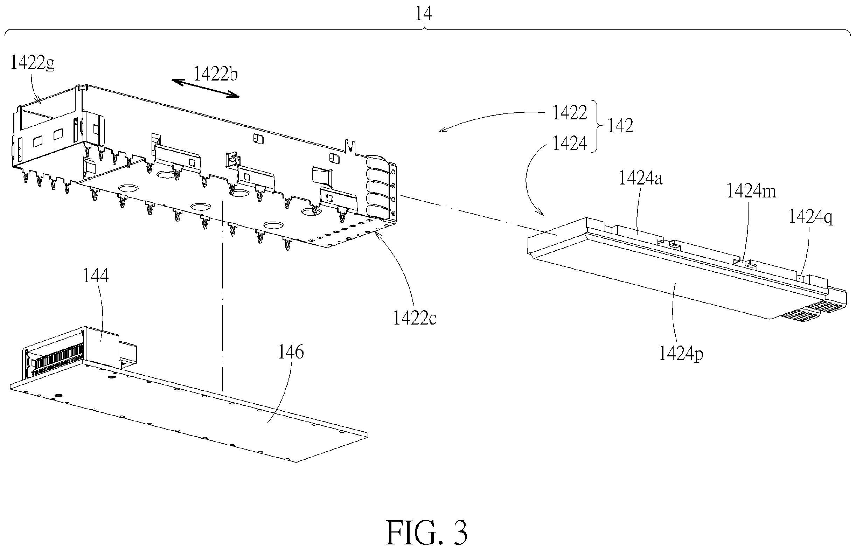

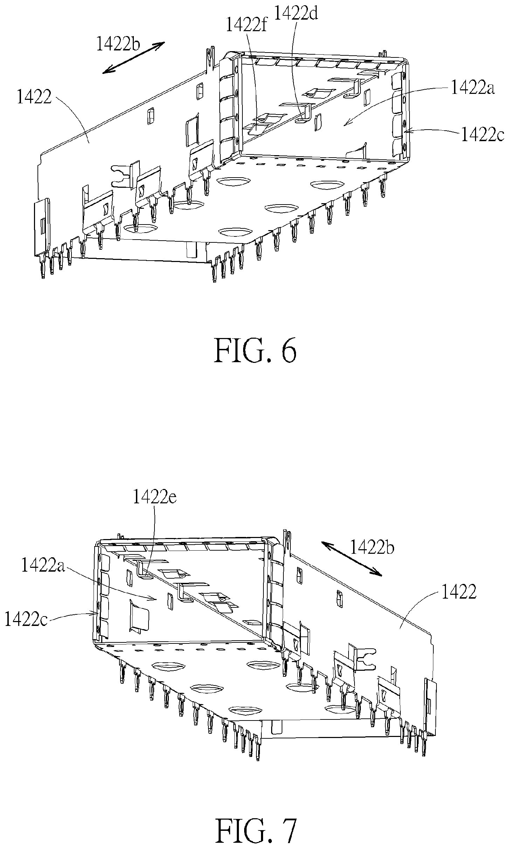

As shown by FIG. 6 and FIG. 7, the cage body 1422 includes a first sliding hook 1422d and a second sliding hook 1422e in the module-receiving slot 1422a, which are located at two sides of the cage body 1422 with respect to the length direction 1422b. **In** the first embodiment, the first sliding hook 1422d and the second sliding hook 1422e are both formed by bending and extending the upper side wall of the cage body 1422, but it is not limited thereto in practice. For example, if an actual product structure allows, the first sliding hook 1422d and the second sliding hook 1422e may alternatively be formed by bending and extending from opposite side walls of the cage body 1422 respectively. As shown by FIG. 3 and FIG. 4, a first sliding slot 1424k and a second sliding slot 1424m are formed on both sides of the liquid cooling component 1424 (or the base 1424a thereof). The liquid cooling component 1424 is fixedly disposed in the cage body 1422 by the first sliding hook 1422d and the second sliding hook 1422e sliding into and hooking the first sliding slot 1424k and the second sliding slot 1424m respectively.

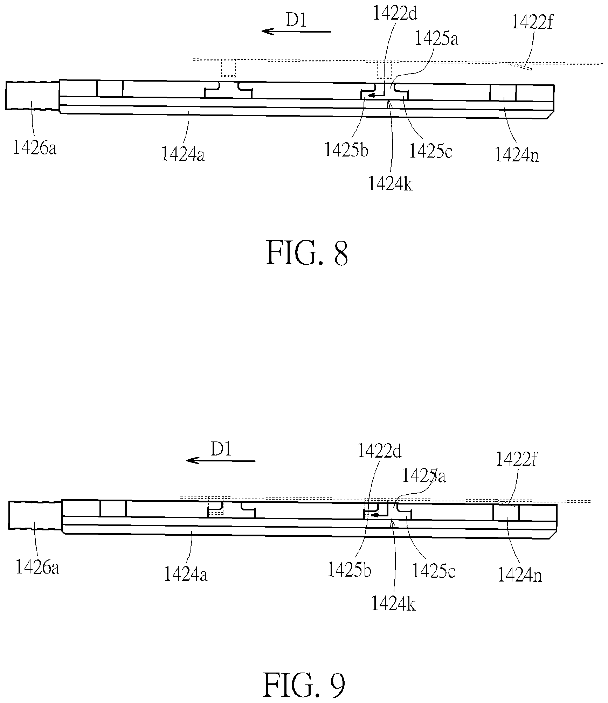

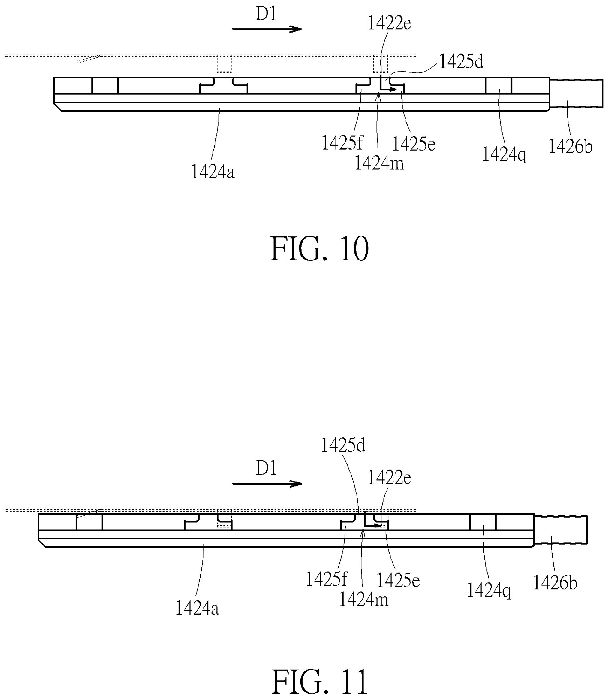

Further, the engagement of the first sliding hook 1422d and the first sliding slot 1424k is shown by FIG. 8 (which is a side view of the liquid cooling component 1424; therein, the outline of the first sliding hook 1422d is shown in dashed lines, and the insertion opening 1422c is at the left side). The first sliding slot 1424k is a T-shaped slot having a first entrance 1425a, a first closed end 1425b and a second closed end 1425c. In the combination of the liquid cooling component 1424 with the cage body 1422, the liquid cooling component 1424 is moved so that the first sliding hook 1422d enters the first sliding slot 1424k from the first entrance 1425a and slides in a sliding direction D1 (indicated by an arrow in the figure) to the first closed end 1425b. The first sliding hook 1422d is engaged to the first sliding slot 1424k as shown in FIG. 9. Furthermore, the engagement of the second sliding hook 1422e and the second sliding slot 1424m is shown by FIG. 10 (which is another side view of the liquid cooling component 1424; therein, the outline of the second sliding hook 1422e is shown in dashed lines, and the insertion opening 1422c is at the right side). The second sliding slot 1424m is a T-shaped slot having a second entrance 1425d, a third closed end 1425e, and a fourth closed end 1425f. In the combination of the liquid cooling component 1424 with the cage body 1422, the liquid cooling component 1424 is moved so that the second sliding hook 1422e enters the second sliding slot 1424m from the second entrance 1425d and slides to the third closed end 1425e in the sliding direction D1. The second sliding hook 1422e is engaged to the second sliding slot 1424m as shown in FIG. 11. At this time, the liquid cooling component 1424 has reached the installation position (relative to the cage body 1422).

Furthermore, in the first embodiment, as showed by FIG. 6, the cage body 1422 also includes a stop spring piece 1422f (e.g., but not limited to an elastic cantilever structure) in the module-receiving slot 1422a. As shown by FIG. 4, the liquid cooling component 1424 (or the base 1424a thereof) forms a recess 1424n. As shown by FIG. 9, after the liquid cooling component 1424 reaches the installation position, the stop spring piece 1422f fits in the recess 1424n to prevent the liquid cooling component 1424 from sliding relative to the cage body 1422 in the direction opposite to the sliding direction D1 (by the free end of the stop spring piece 1422f abutting against the side wall of the recess 1424n). At this time, the liquid cooling component 1424 remains fixed to the cage body 1422.

As shown by FIG. 1 and FIG. 3, the liquid cooling component 1424 has a first flat heat-conducting surface 1424p (implemented by the bottom surface of the base 1424a). The first flat heat-conducting surface 1424p is exposed in the module-receiving slot 1422a. The optical transceiver module 12 includes a module housing 122 and an edge connector 124. The module housing 122 includes a main housing 1222 and two vertical plates 1224. The main housing 1222 has a third flat heat-conducting surface 1222a. The two vertical plates 1224 protrude from the third flat heat-conducting surface 1222a. The two vertical plates 1224 extend parallel to the length direction (equivalent to the length direction 1422b) of the module housing 122 and are located on opposite sides of the main housing 1222. A structure-less space 1226 (indicated by a dashed box in FIG. 1) is formed between the two vertical plates 1224 and the third flat heat-conducting surface 1222a. The edge connector 124 is exposed on a side of the module housing 122 in the length direction of the module housing 122. The optical transceiver module 12 is inserted into the module-receiving slot 1422a, so that the liquid cooling component 1424 enters the structure-less space 1226 between the two vertical plates 1224, the edge connector 124 is inserted into the connector socket 144 of the optical transceiver module socket 14, and the third flat heat-conducting surface 1222a contacts the first flat heat-conducting surface 1424p of the liquid cooling component 1424 in the module-receiving slot 1422a. This large surface contact can increase the efficiency of the liquid cooling component 1424 in absorbing heat from the optical transceiver module 12. In addition, in practice, the module housing 122 may not have the vertical plates 1224.

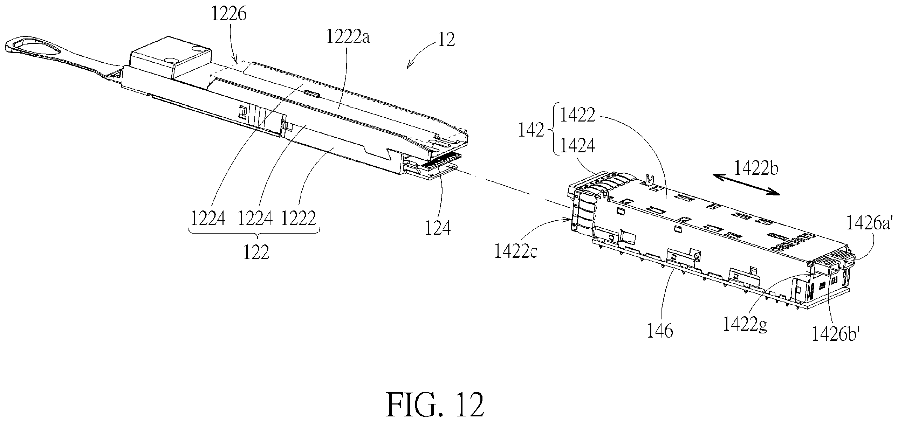

Furthermore, as shown FIG. 1 and FIG. 4, the inlet 1424d and the outlet 1424e of the flow channel structure 1424c of the liquid cooling component 1424 are both located on a side of the liquid cooling component 1424 close to the insertion opening 1422c in the length direction 1422b. In other words, the inlet 1424d and the outlet 1424e are located on the front side (defined as the side close to the insertion opening 1422c) of optical transceiver module socket 14. In the first embodiment, the cage body 1422 has an opening 1422g on the other side opposite to the insertion opening 1422c. The liquid cooling component 1424 can be rotated 180 degrees and installed in the cage body 1422 as required, as shown by FIG. 12 (therein, the length the transfer tubes 1426a' and 1426b' in the figure are lengthened (relative to the transfer tubes 1426a and 1426b) to accommodate this configuration; that is, they are lengthened to protrude from the cage body 1422 through the opening 1422g to facilitate connection with the manifold of the external cooling system). The installation is described below.

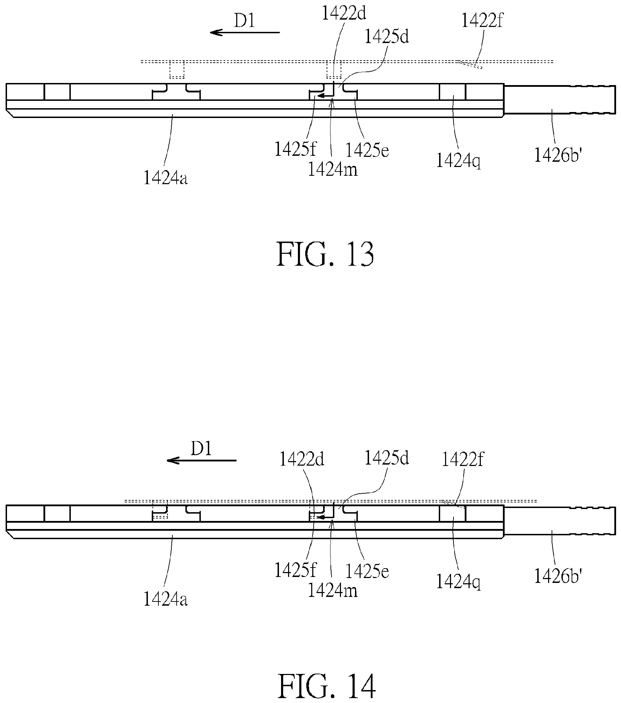

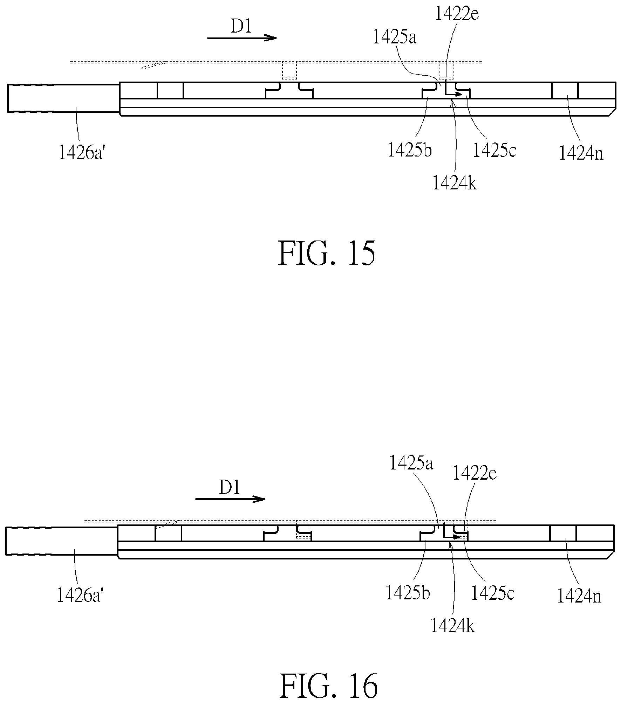

Please refer to FIG. 3 and FIG. 4. The liquid cooling component 1424 (or the base 1424a thereof) forms a recess 1424q. As shown by FIG. 13 (which is a side view of the liquid cooling component 1424; therein, the outline of the first sliding hook 1422d is shown in dashed lines, and the insertion opening 1422c is at the left side, not shown in the figure), in the combination of the liquid cooling component 1424 with the cage body 1422, the liquid cooling component 1424 is moved so that the first sliding hook 1422d enters the second sliding slot 1424m from the second entrance 1425d and slides in the sliding direction D1 to the fourth closed end 1425f, and the stop spring piece 1422f fits in the recess 1424q. The first sliding hook 1422d is engaged to the second sliding slot 1424m as shown in FIG. 9. Furthermore, as shown by FIG. 15 (which is another side view of the liquid cooling component 1424; therein, the outline of the second sliding hook 1422e is shown in dashed lines, and the insertion opening 1422c is at the right side, not shown in the figure), in the combination of the liquid cooling component 1424 with the cage body 1422, the liquid cooling component 1424 is moved so that the second sliding hook 1422e enters the first sliding slot 1424k from the first entrance 1425a and slides in the sliding direction D1 to the second closed end 1425c. The second sliding hook 1422e is engaged to the first sliding slot 1424k as shown in FIG. 16. At this time, the liquid cooling component 1424 has reached the installation position (relative to the cage body 1422). The inlet 1424d and the outlet 1424e of the flow channel structure 1424c of the liquid cooling component 1424 are both located on a side of the liquid cooling component 1424 away from the insertion opening 1422c in the length direction 1422b. In other words, the inlet 1424d and the outlet 1424e are located on the rear side (defined as the side away from the insertion opening 1422c) of optical transceiver module socket 14. Therefore, at least the liquid cooling component 1424 itself can be adapted for installation in different directions (to the cage body 1422), thereby increasing the versatility of the liquid cooling component 1424 and reducing manufacturing costs.

In addition, in the first embodiment, the first sliding hook 1422d and the second sliding hook 1422e are disposed in the cage body 1422, and the first sliding slot 1424k and the second sliding slot 1424m are disposed on the liquid cooling component 1424; however, it is not limited thereto in practice. For example, the same effect can also be achieved by swapping the above structures, which will not be described in addition. Similarly, the structures of the stop spring piece 1422f and the recesses 1424n, 1424q in the first embodiment can also be swapped to achieve the same effect, which will not be described in addition.

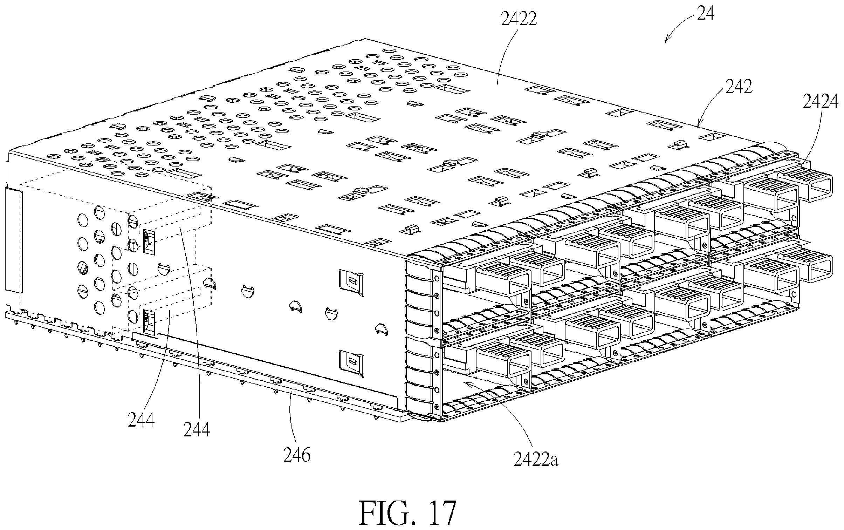

In addition, in the first embodiment, the optical transceiver module socket 14 is described by taking a single slot (i.e., the module-receiving slot 1422a) as an example; however, it is not limited thereto in practice. For example, please refer to FIG. 17. An optical transceiver module socket 24 according to a second embodiment is a 2x4 socket, providing a total of eight module-receiving slots 2422a (one of which is selected to be labeled in the figure). In structural logic, the optical transceiver module socket 24 is equivalent to a combination of eight optical transceiver module sockets 14 (arranged in two rows, upper and lower). Therefore, for other descriptions about the optical transceiver module socket 24, please directly refer to the previous description about the optical transceiver module socket 14 and its variations. In brief, the optical transceiver module socket 24 includes an optical transceiver module socket cage 242, eight connector sockets 244, and a circuit board 246. The eight connector sockets 244 are electrically fixed on the circuit board 246; therein, every two connector sockets 244 (arranged vertically adjacent to each other) are structurally integrated into the same connector body. For example, the outline of one of the connector bodies is shown in the figure (in dashed lines). The optical transceiver module socket cage 242 includes a cage body 2422 and eight liquid cooling components 2424 (one of which is selected to be labeled in the figure). The cage body 2422 forms eight module-receiving slots 2422a and is fixed on the circuit board 246, so that the eight connector sockets 244 are located in the optical transceiver module socket cage 242 and exposed in the eight module-receiving slots 2422a respectively. The eight liquid cooling components 2424 are fixedly disposed in the cage body 2422 and exposed in the eight module-receiving slots 1422a respectively. In practical applications, each of the eight module-receiving slots 2422a can receive an optical transceiver module (e.g., the optical transceiver module 12 mentioned above), which will not be described in addition.

In addition, in the optical transceiver module socket 24, (in the viewpoint of FIG. 17) because the circuit board 246 is located under the cage body 2422, the connector socket 244 on the upper row will pass through the module-receiving slot 2422a on the lower row, so that the inlet and outlet of the flow channel structure of the liquid cooling component 2424 on the lower row are not easy to be arranged backward in principle. In the second embodiment, the inlets and outlets of the flow channel structures of the upper and lower rows of liquid cooling components 2424 are all arranged forward; however, it is not limited thereto in practice. For example, the inlets and outlets of the flow channel structures of the upper row of the liquid cooling components 2424 are changed to be arranged toward the rear; in this case, opening structures need to be formed at the corresponding positions on the rear side of the cage body 2422 to allow them to pass through. Furthermore, in practice, the flow channel structures of adjacent liquid cooling components 2424 in the same row can be designed to be connected in series.

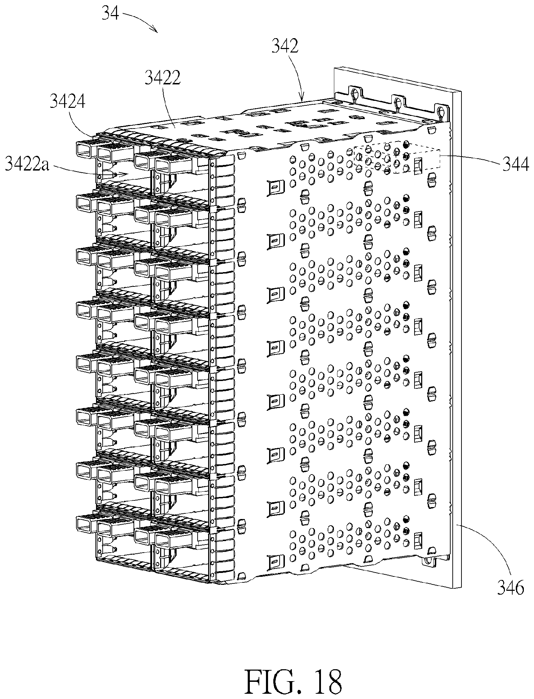

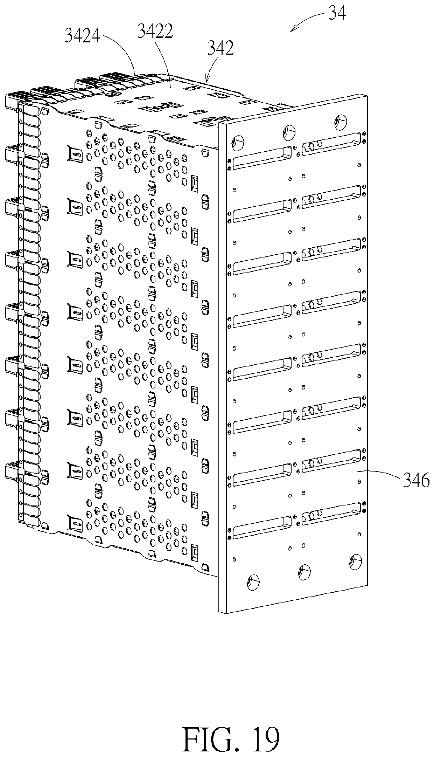

For another example, please refer to FIG. 18 and FIG. 19. An optical transceiver module socket 34 according to a third embodiment is an 8x2 socket, providing a total of sixteen module-receiving slots 3422a (one of which is selected to be labeled in the figure). In structural logic, the optical transceiver module socket 34 is equivalent to a combination of sixteen optical transceiver module sockets 14 (arranged in four rows, two for each row). Therefore, for other descriptions about the optical transceiver module socket 34, please directly refer to the previous description about the optical transceiver module socket 14 and its variations. In brief, the optical transceiver module socket 34 includes an optical transceiver module socket cage 342, sixteen connector sockets 344 (the outline of one of which is selected to be shown in dashed lines in the figure), and a circuit board 346. The sixteen connector sockets 344 are individually electrically fixed on the circuit board 346. The optical transceiver module socket cage 342 includes a cage body 3422 and sixteen liquid cooling components 3424 (one of which is selected to be labeled in the figure). The cage body 3422 forms the sixteen module-receiving slots 3422a and is fixed on the circuit board 346, so that the sixteen connector sockets 344 are located in the optical transceiver module socket cage 342 and exposed in the sixteen module-receiving slots 2422a respectively. In practical applications, each of the sixteen module-receiving slots 3422a can receive an optical transceiver module (e.g., the optical transceiver module 12 mentioned above), which will not be described in addition.

In addition, in the optical transceiver module socket 34, (in the viewpoint of FIG. 18) the circuit board 346 is located at the rear side of the cage body 3422, so that the sixteen module-receiving slots 3422a can be directly fixed on the circuit board 346 without passing through other module-receiving slots 3422a. Therefore, the inlets and outlets of the flow channel structures of the sixteen liquid cooling components 3424 can be changed to be arranged toward the rear. In this case, opening structures (as shown in FIG. 19) need to be formed at the corresponding positions on the rear side of the cage body 3422 and the circuit board 346 to allow them to pass through. Furthermore, in practice, the flow channel structures of adjacent liquid cooling components 3424 in the same row can be designed to be connected in series. Furthermore, the flow channel structures of vertically adjacent liquid cooling components 3424 can also be designed to be connected in series as required.

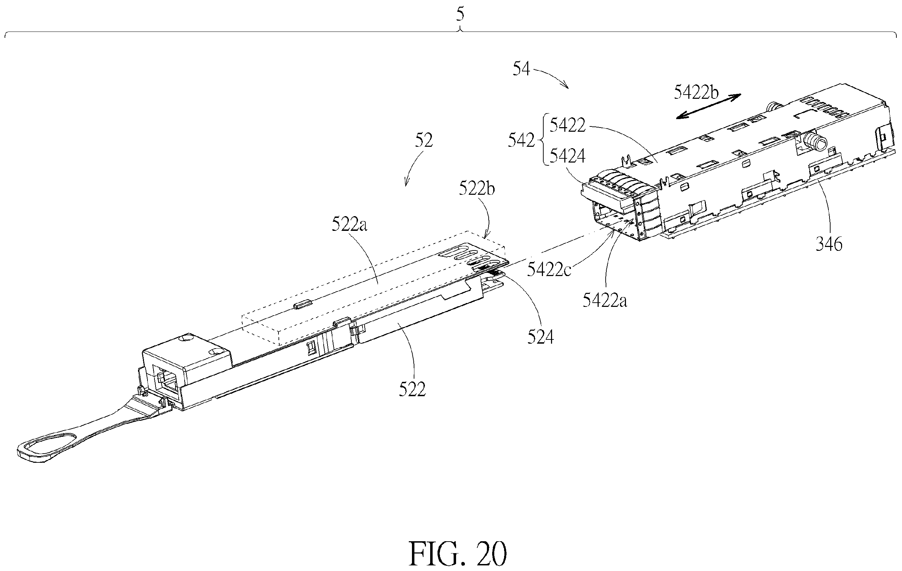

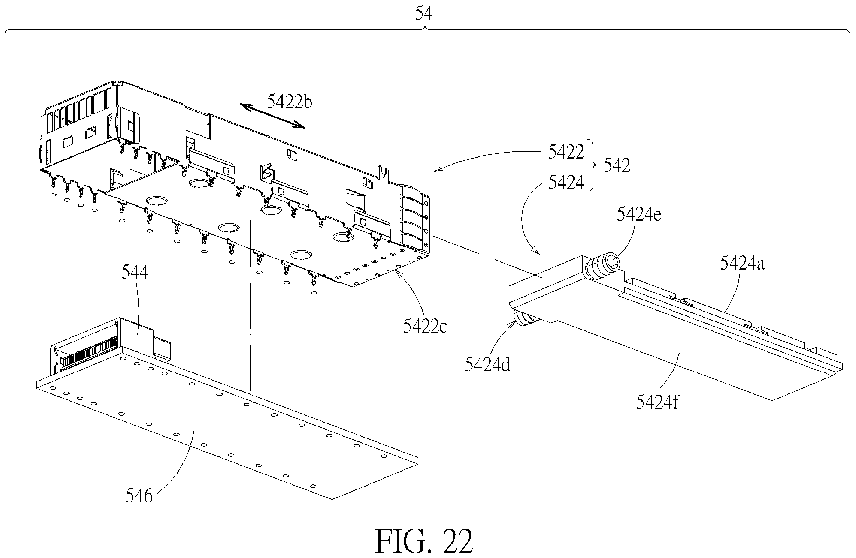

Please refer to FIG. 20 to FIG. 22. An optical transceiver module set 5 according to a fourth embodiment includes an optical transceiver module 52 and an optical transceiver module socket 54. The optical transceiver module socket 54 includes an optical transceiver module socket cage 542, a connector socket 544, and a circuit board 546. The optical transceiver module socket cage 542 includes a cage body 5422 and a liquid cooling component 5424. The cage body 5422 forms a module-receiving slot 5422a which has a length direction 5422b (indicated by a doubled-headed arrow in the figures) and an insertion opening 5422c in the length direction 5422b. The liquid cooling component 5424 is fixedly disposed in the cage body 5422 and exposed in the module-receiving slot 5422a. The connector socket 544 is electrically fixed on the circuit board 546. The cage body 5422 is fixed on the circuit board 546, so that the connector socket 544 is located in the module-receiving slot 5422a. The optical transceiver module 52 can be inserted into the module-receiving slot 5422a from the insertion opening 5422c parallel to the length direction 5422b to engage with the connector socket 544 and contact the liquid cooling component 5424. Thereby, heat generated by the optical transceiver module 52 during operation can be transferred to the liquid cooling component 5424 (equivalent to a heat exchanger) to achieve a heat dissipation effect.

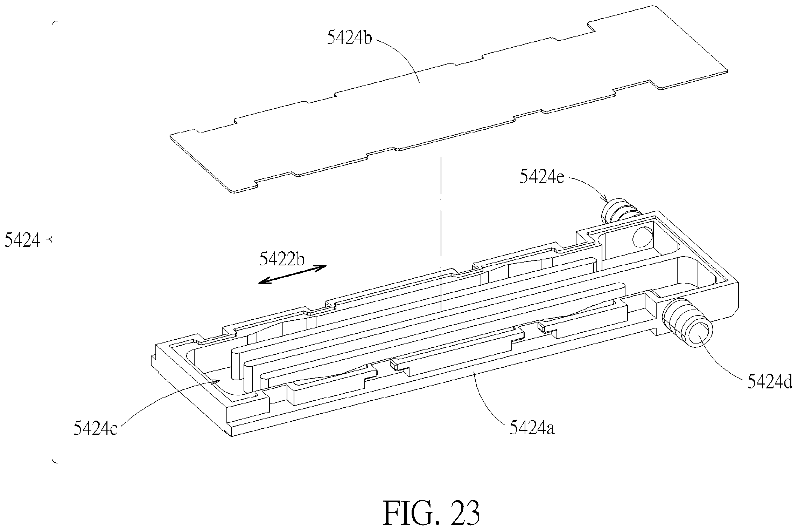

Please refer to FIG. 23. The liquid cooling component 5424 includes a base 5424a and a top cover 5424b. The base 5424a forms a flow channel structure 5424c and an inlet 5424d and an outlet 5424e which are connected to the flow channel structure 5424c. The top cover 5424b is fixed on the base 5424a (for example, but limited to tight fitting and/or soldering) to cover the flow channel structure 5424c. The working fluid (not shown in the figures) flows through the flow channel structure 5424c through the inlet 5424d and the outlet 5424e to remove the heat absorbed by the base 5424a. Compared to the liquid cooling component 1424 in the first embodiment, except for the different in the positions of the inlet 5424d and the outlet 5424e, the liquid cooling component 5424 of this embodiment and the liquid cooling component 1424 (in the first embodiment) are substantially the same in structure. Therefore, for other descriptions about the liquid cooling component 5424, please directly refer to the previous description about the liquid cooling component 1424, which will not be described in addition. In this embodiment, the inlet 5424d and the outlet 5424e are located on opposite sides of the liquid cooling component 5424 in a direction perpendicular to the length direction 5422b. The cage body 5422 forms openings on the side walls corresponding to the inlet 5424d and the outlet 5424e to allow them to pass through.

In addition, in this embodiment, the combination of the liquid cooling component 5424 and the cage body 5422 is in principle the same as the combination of the liquid cooling component 1424 and the cage body 1422 (in the first embodiment) in the previous description, which will not be repeated in addition.

Furthermore, in this embodiment, as shown by FIG. 20 to FIG. 22, the liquid cooling component 5424 has a first flat heat-conducting surface 5424f (implemented by the bottom surface of the base 5424a). The first flat heat-conducting surface 5424f is exposed in the module-receiving slot 5422a. The optical transceiver module 52 includes a module housing 522 and an edge connector 524. The module housing 522 has a third flat heat-conducting surface 522a, with no other structure above it, forming a structure-less space 522b (indicated by a dashed box in FIG. 20). The edge connector 524 is exposed on a side of the module housing 522 in the length direction (parallel to the length direction 5422b of the module-receiving slot 5422a) of the module housing 522. The optical transceiver module 52 is inserted into the module-receiving slot 5422a, so that the liquid cooling component 5424 enters the structure-less space 522b above the third flat heat-conducting surface 522a, the edge connector 524 is inserted into the connector socket 544 of the optical transceiver module socket 54, and the third flat heat-conducting surface 522a contacts the flat heat-conducting surface 5424f of the liquid cooling component 5424 in the module-receiving slot 5422a. This large surface contact can increase the efficiency of the liquid cooling component 5424 in absorbing heat from the optical transceiver module 52. In addition, in practice, if the structural configuration allows (e.g., there is enough space between the liquid cooling component 5424 and the cage body 5422), the module housing 522 may also have vertical plates so that the overall appearance is similar to the module housing 122 (in the first embodiment).

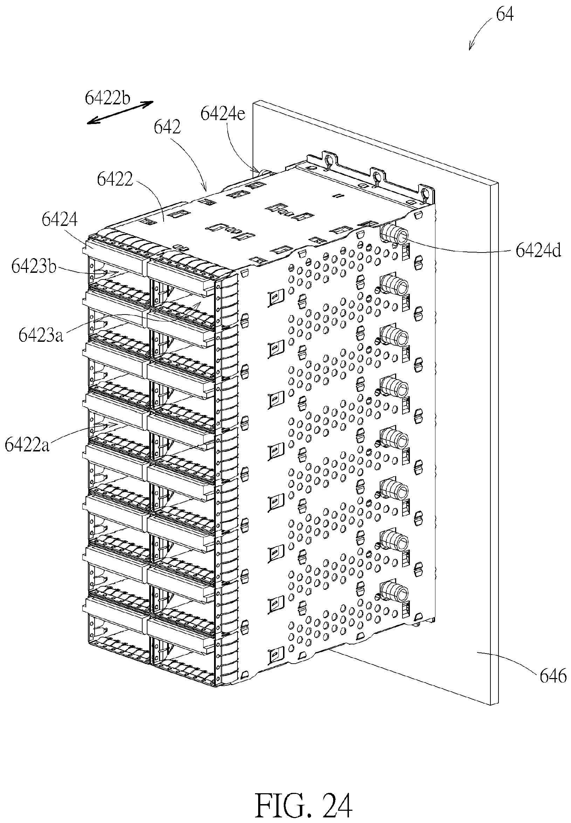

Please refer to FIG. 24 to FIG. 26. An optical transceiver module socket 64 according to a fifth embodiment is an 8x2 socket, providing a total of sixteen module-receiving slots 6422a (one of which is selected to be labeled in the figure). The optical transceiver module socket 64 includes an optical transceiver module socket cage 642, sixteen connector sockets 644 (one of which is selected to be labeled in the figure), and a circuit board 646. The optical transceiver module socket cage 642 includes a cage body 6422 and eight liquid cooling components 6424. The cage body 6422 forms the sixteen module-receiving slots 6422a. The module-receiving slot 6422a has a length direction 6422b (indicated by a doubled-headed arrow in the figures) and has an insertion opening 6422c in the length direction 6422b. Each liquid cooling component 6424 corresponds to two module-receiving slot 6422a (e.g., a first module-receiving slot 6423a and a second module-receiving slot 6423b that are arranged in parallel and adjacent to each other). The liquid cooling component 6424 is fixedly disposed in the cage body 6422 and is exposed in the corresponding module-receiving slots 6422a. The connector socket 644 is electrically fixed on the circuit board 646. The cage body 6422 is fixed on the circuit board 646, so that the connector sockets 644 are located in the module-receiving slots 6422a. An optical transceiver module (such as the optical transceiver module 52 in the fourth embodiment) can be inserted into the module-receiving slot 6422a from the insertion opening 6422c parallel to the length direction 6422b to connect with the corresponding connector socket 644 and contact the corresponding liquid cooling component 6424. Thereby, heat generated by the optical transceiver module during operation can be transferred to the corresponding liquid cooling component 6424 (equivalent to a heat exchanger) to achieve a heat dissipation effect.

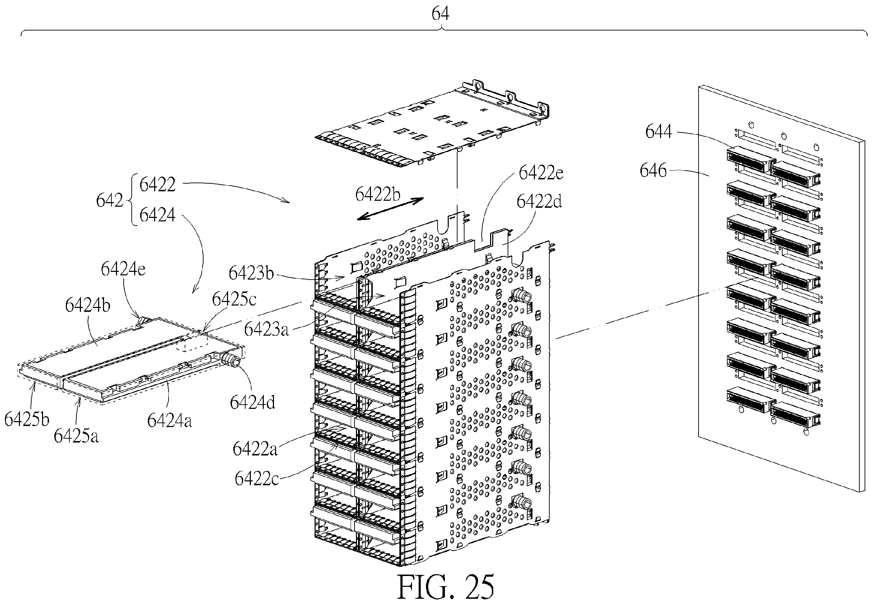

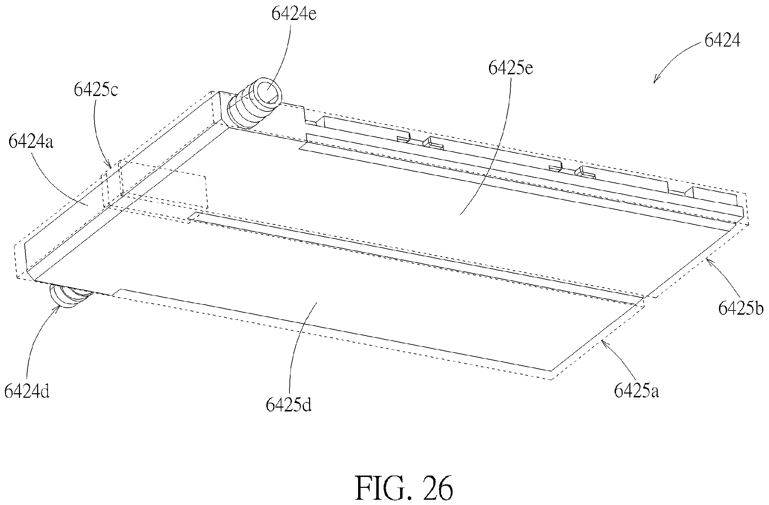

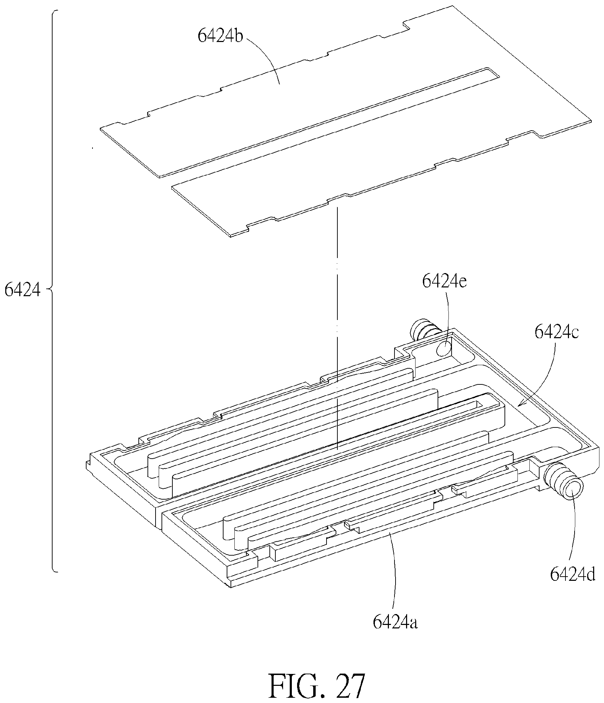

Please refer to FIG. 25 to FIG. 28. Further, the liquid cooling component 6424 includes a base 6424a and a top cover 6424b. The base 6424a forms a flow channel structure 6424c and an inlet 6424d and an outlet 6424e which are connected to the flow channel structure 6424c. The top cover 6424b is fixed on the base 6424a (for example, but limited to tight fitting and/or soldering) to cover the flow channel structure 6424c. The working fluid (not shown in the figures) flows through the flow channel structure 6424c through the inlet 6424d and the outlet 6424e to remove the heat absorbed by the base 6424a. Taking the liquid cooling component 6424 as a whole, the liquid cooling component 6424 includes a first structural portion 6425a, a second structural portion 6425b and a structural connection portion 6425c (the approximate ranges of which are indicated by dashed boxes in FIGS. 25 and 26). The first structural portion 6425a and the second structural portion 6425b are separated from each other but are connected through the structural connection portion 6425c. The first structural portion 6425a, the second structural portion 6425b, and the structural connection portion 6425c together form the flow channel structure 6424c. The first structural portion 6425a (or the first flat heat-conducting surface 6425d thereof) is exposed in the first module-receiving slot 6423a. The second structural portion 6425b (or the second flat heat-conducting surface 6425e thereof) is exposed in the second module-receiving slot 6423b (referring to FIG. 24), so that the third flat heat-conducting surface 522a of the optical transceiver module 52 (referring to FIG. 20) inserted into the first module-receiving slot 6423a or the second module-receiving slot 6423b can contact the first flat heat-conducting surface 6425d or the second flat heat-conducting surface 6425e correspondingly.

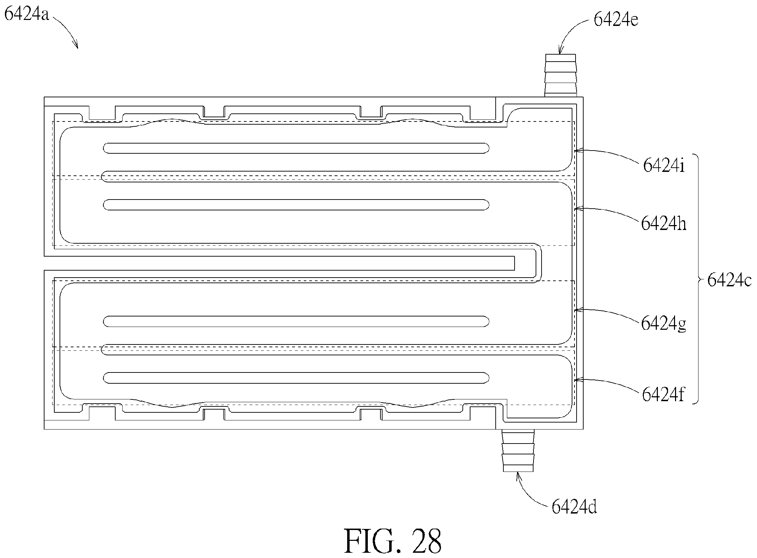

Furthermore, the flow channel structure 6424c includes a first flow channel portion 6424f, a second flow channel portion 6424g, a third flow channel portion 6424h, and a fourth flow channel portion 6424i (which are indicated by dashed blocks in FIG. 28), which extend the length direction 6422b. Therein, the first structural portion 6425a forms the first flow channel portion 6424f and the second flow channel portion 6424g, corresponding to the first module-receiving slot 6423a, and the second structural portion 6425b forms the third flow channel portion 6424h and the fourth flow channel portion 6424i, corresponding to the second module-receiving slot 6423b. The second flow channel portion 6424g is connected to the third flow channel portion 6424h through the structural connection portion 6425c. The inlet 6424d, the first flow channel portion 6424f, the second flow channel portion 6424g, the third flow channel portion 6424h, the fourth flow channel portion 6424i, and the outlet 6424e are connected in sequence. (Similar to the flow channel structure 1424c in the first embodiment described above) each of the first flow channel portion 6424f, the second flow channel portion 6424g, the third flow channel portion 6424h, and the fourth flow channel portion 6424i includes two sub-flow channels (not labeled in FIG. 28). For related descriptions, please refer to the previous descriptions of the sub-flow channels 1424h of the flow channel structure 1424c, which will not be repeated in addition. In addition, the flow channel structures of vertically adjacent liquid cooling components 6424 can also be designed to be connected in series as required.

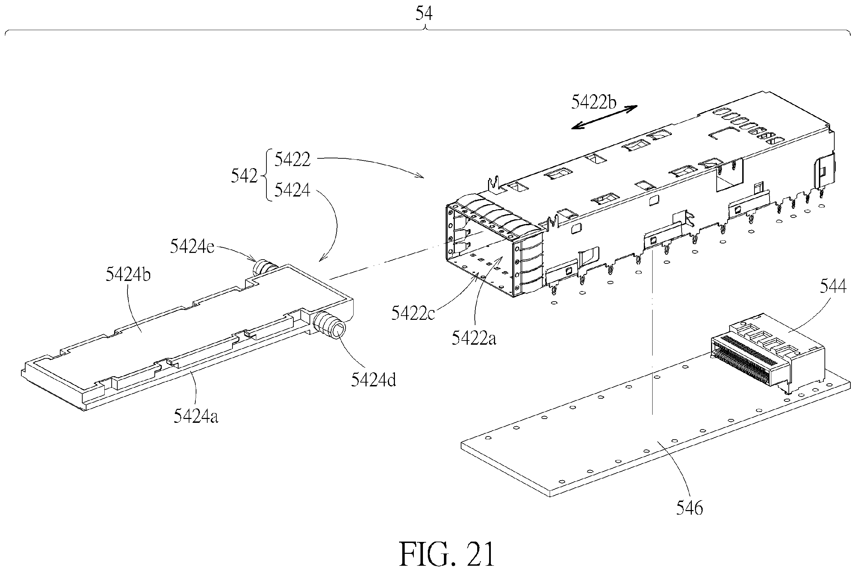

Furthermore, in structural logic, the liquid cooling component 6424 is equivalent to a combination of two liquid cooling components 5424 (in the fourth embodiment; referring to FIG. 21 and FIG. 23). For other descriptions about the liquid cooling component 6424 itself, please directly refer to the previous description about the liquid cooling component 5424, which will not be described. In addition, the combination of liquid cooling component 6424 and cage body 6422 is in principle substantially the same as the combination of liquid cooling component 5424 and cage body 5422 in the previous description. Therefore, for other descriptions about the combination of liquid cooling component 6424 and cage body 6422, please refer to the previous description about the combination of liquid cooling component 5424 and cage body 5422, which will not be described in addition. In this embodiment, as shown by FIG. 25, the cage body 6422 has a separation wall 6422d (implemented by two parallel plates in this embodiment), which is located between the first module-receiving slot 6423a and the second module-receiving slot 6423b and has a notch 6422e. The structural connection portion 6425c fits in the notch 6422e. In practice, the separation wall 6422d can provide a certain degree of support (in the vertical direction) to the liquid cooling component 6424 through the notch 6422e.

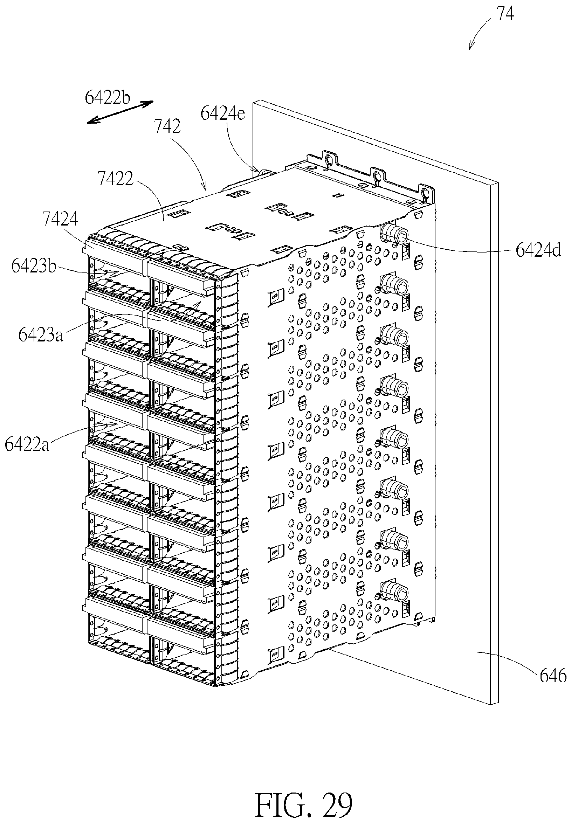

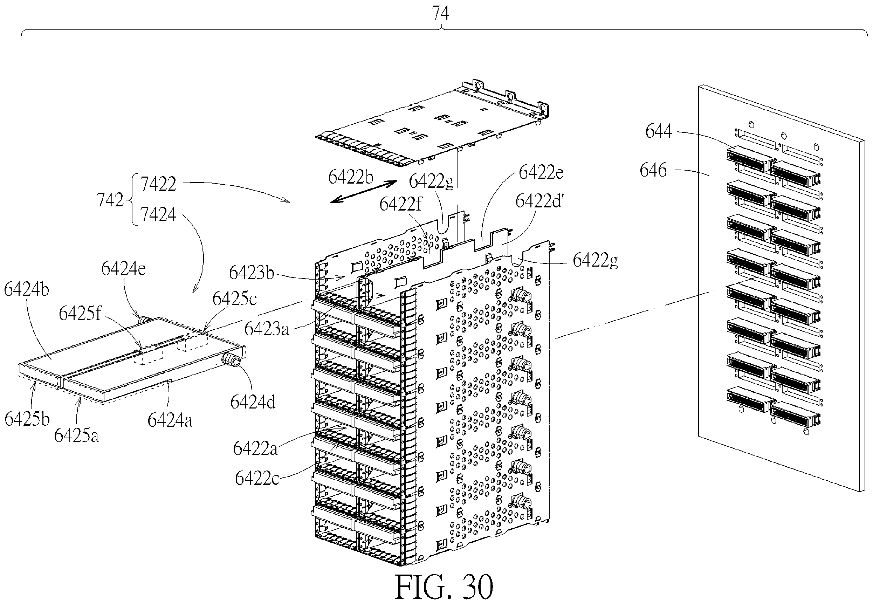

Please refer to FIG. 29 and FIG. 30. An optical transceiver module socket 74 according to a sixth embodiment is structurally similar to the optical transceiver module socket 64 (in the fifth embodiment), so in principle, the optical transceiver module socket 74 uses the component reference numbers of the optical transceiver module socket 64. For other descriptions about the optical transceiver module socket 74, please refer to the previous description about the optical transceiver module socket 64, which will not be described in addition. A main difference is that in an optical transceiver module socket cage 742 of the optical transceiver module socket 74, the combination of a liquid cooling component 7424 and a cage body 7422 does not use structures such as a sliding hook and a sliding slot (such as the first sliding hook 1422d and the first sliding slot 1424k in the first embodiment). Compared to the liquid cooling component 6424 (of the fifth embodiment), the liquid cooling component 7424 further includes a middle connection portion 6425f. The first structural portion 6425a and the second structural portion 6425b are separated from each other but are connected through the structural connection portion 6425c and the middle connection portion 6425f. The structural connection portion 6425c and the middle connection portion 6425f are separated from each other. A separation wall 6422d' of the cage body 7422 further includes a notch 6422f. The middle connection portion 6425f fits in the notch 6422f. In this embodiment, the notches 6422e and 6422f and the openings 6422g on the side walls (for the inlet 6424d and the outlet 6424e of the liquid cooling component 7424 to pass through) are not arranged in a co-linear manner, so they can jointly provide effective (vertical) support for the liquid cooling component 7424. Furthermore, the notches 6422e and 6422f also limit the position of the liquid cooling component 7424 in the length direction 6422b (i.e., horizontal positioning). Thereby, the liquid cooling component 7424 can be firmly fixed in the cage body 7422.

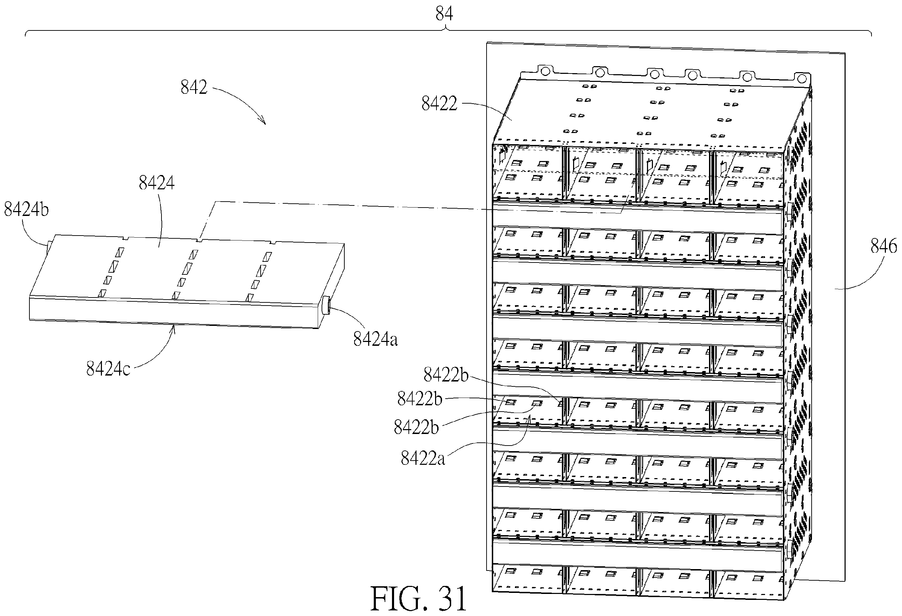

Please refer to FIG. 31. An optical transceiver module socket 84 according to a seventh embodiment is an 8x4 socket. A cage body 8422 of an optical transceiver module socket cage 842 of the optical transceiver module socket 84 forms thirty-two module-receiving slots 8422a (one of which is selected to be labeled in the figure) and is fixed on a circuit board 846. A connector socket (electrically fixed to the circuit board 846; not shown in the figure) is correspondingly disposed in each of the module-receiving slots 8422a. In structural logic, the optical transceiver module socket 84 is structurally similar to the optical transceiver module socket 74 (in the sixth embodiment). Therefore, for other descriptions about the optical transceiver module socket 84, please refer to the previous description about the optical transceiver module socket 74, which will not be described in addition. A main difference is that each of liquid cooling components 8424 of the optical transceiver module socket cage 842 provides heat exchange function for four module-receiving slots 8422a at the same time (therein, the original setting position of the exploded liquid cooling component 8424 in the figure is indicated by dashed lines). The liquid cooling component 8424 still uses a single inlet 8424a and a single outlet 8424b to allow the working fluid to flow through the internal flow channel structure. Furthermore, in the module-receiving slot 8422a, the age body 8422 further includes a plurality of spring pieces 8422b (arranged on the lower side wall of the module-receiving slot 8422a relative to the liquid cooling component 8424), so that an optical transceiver module (e.g., the optical transceiver module 52 in FIG. 20) inserted into the module-receiving slot 8422a is pushed toward the liquid cooling component 8424 by the plurality of spring pieces 8422b to make the flat heat-conducting surface (e.g., the third flat heat-conducting surface 522a of the optical transceiver module 52 ) kept tightly against the flat heat-conducting surface 8424c of the liquid cooling component 8424 (on the bottom thereof), thereby ensuring heat exchange between the optical transceiver module and the liquid cooling component 8424.

In addition, in the above embodiments, if there are any structural designs of the optical transceiver modules 12, 52 and the optical transceiver module sockets 14, 24, 34, 54, 64, 74, 84 that can be referenced and applied to each other in practice, they can also be applied to each other, which will not be described further in addition.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. An optical transceiver module socket cage (142), **characterized by** comprising:
a cage body (1422), the cage body (1422) forming a first module-receiving slot (1422a); and
a liquid cooling component (1424), the liquid cooling component (1424) having a flow channel structure (1424c) and an inlet (1424d) and an outlet (1424e) which are connected to the flow channel structure (1424c), the liquid cooling component (1424) being fixedly disposed in the cage body (1422) and being exposed in the first module-receiving slot (1422a).

2. The optical transceiver module socket cage (142) according to claim 1, **characterized in that** the liquid cooling component (1424) has a first flat heat-conducting surface (1424p), and the first flat heat-conducting surface (1424p) is exposed in the first module-receiving slot (1422a).

3. The optical transceiver module socket cage (142) according to claim 1, **characterized in that** one of the liquid cooling component (1424) and the cage body (1422) comprises a sliding hook (1422d), the other of the liquid cooling component (1424) and the cage body (1422) comprises a sliding slot (1424k), and the liquid cooling component (1424) is fixed to the cage body (1422) by the sliding hook (1422d) sliding into and hooking the sliding slot (1424k).

4. The optical transceiver module socket cage (142) according to claim 3, **characterized in that** the sliding hook (1422d) slides into the sliding slot (1422k) in a sliding direction (D1), one of the liquid cooling component (1424) and the cage body (1422) comprises a stop spring piece (1422f), the other of the liquid cooling component (1424) and the cage body (1422) comprises a recess (1424n), and the stop spring piece (1422f) fits in the recess (1424n) to prevent the liquid cooling component (1424) from sliding relative to the cage body (1422) in a direction opposite to the sliding direction (D1).

5. The optical transceiver module socket cage (142) according to claim 1, **characterized in that** the first module-receiving slot (1422a) has a length direction (1422b), the flow channel structure (1424c) comprises a first flow channel portion (1424f) and a second flow channel portion (1424g), the first flow channel portion (1424f) and the second flow channel portion (1424g) extend parallel to the length direction (1422b), and the inlet (1424d), the first flow channel portion (1424f), the second flow channel portion (1424g), and the outlet (1424e) are connected in sequence.

6. The optical transceiver module socket cage (142) according to claim 5, **characterized in that** the first flow channel portion (1424f) or the second flow channel portion (1424g) comprises two sub-flow channels (1424h), and the two sub-flow channels (1424h) extend parallel to the length direction (1422b) and are connected in parallel.

7. The optical transceiver module socket cage (642) according to claim 5, **characterized in that** the cage body (6422) forms a second module-receiving slot (6423b), the first module-receiving slot (6423a) and the second module-receiving slot (6423b) are arranged in parallel and adjacent to each other, the liquid cooling component (6424) is also exposed in the second module-receiving slot (6423b), the flow channel structure (6424c) comprises a third flow channel portion (6424h) and a fourth flow channel portion (6424i), the first flow channel portion (6424f) and the second flow channel portion (6424g) correspond to the first module-receiving slot (6423a), the third flow channel portion (6424h) and the fourth flow channel portion (6424i) extend parallel to the length direction (6422b) and correspond to the second module-receiving slot (6423b), and the inlet (6424d), the first flow channel portion (6424f), the second flow channel portion (6424g), the third flow channel portion (6424h), the fourth flow channel portion (6424i), and the outlet (6424e) are connected in sequence.

8. The optical transceiver module socket cage (142) according to claim 1, **characterized in that** the first module-receiving slot (1422a) has a length direction (1422b) and has an insertion opening (1422c) in the length direction (1422b), and the inlet (1424d) and the outlet (1424e) are both located on a side of the liquid cooling component (1424) close to or away from the insertion opening (1422c) in the length direction (1422b).

9. The optical transceiver module socket cage (142) according to claim 8, **characterized in that** the cage body (1422) comprises a sliding hook (1422d), the liquid cooling component (1424) comprises a first sliding slot (1424k) and a second sliding slot (1424m), when the liquid cooling component (1424) is fixed to the cage body (1422) by the sliding hook (1422d) sliding into and hooking the first sliding slot (1424k), the inlet (1424d) and the outlet (1424e) are relatively close to the insertion opening (1422c), and when the liquid cooling component (1424) is fixed to the cage body (1422) by the sliding hook (1422d) sliding into and hooking the second sliding slot (1424m), the inlet (1424d) and the outlet (1424e) are relatively away from the insertion opening (1422c).

10. The optical transceiver module socket cage (142) according to claim 1, **characterized in that** the first module-receiving slot (1422a) has a length direction (1422b), and the inlet (1424d) and the outlet (1424e) are located on opposite sides of the liquid cooling component (1424) in a direction perpendicular to the length direction (1422b).

11. The optical transceiver module socket cage (742) according to claim 10, **characterized in that** the cage body (7422) forms a second module-receiving slot (6423b), the first module-receiving slot (6423a) and the second module-receiving slot (6423b) are arranged in parallel and adjacent to each other, the cage body (7422) has a separation wall (6422d'), the separation wall (6422d') is located between the first module-receiving slot (6423a) and the second module-receiving slot (6423b) and has a notch (6422f), the liquid cooling component (7424) comprises a first structural portion (6425a), a second structural portion (6425b), a structural connection portion (6425c), and a middle connection portion (6425f), the first structural portion (6425a) and the second structural portion (6425b) are separated from each other but are connected through the structural connection portion (6425c) and the middle connection portion (6425f), the structural connection portion (6425c) and the middle connection portion (6425f) are separated from each other, the first structural portion (6425a), the second structural portion (6425b), and the structural connection portion (6425c) together form the flow channel structure (6424c), the first structural portion (6425a) is exposed in the first module-receiving slot (6423a), the second structural portion (6425b) is exposed in the second module-receiving slot (6423b), and the middle connection portion (6425f) fits in the notch (6422f).

12. The optical transceiver module socket cage (142) according to claim 1, **characterized in that** the liquid cooling component (1424) comprises a base (1424a) and a top cover (1424b), the base (1424a) forms the flow channel structure (1424c), and the top cover (1424b) is fixed to the base (1424a) to cover the flow channel structure (1424c).

13. The optical transceiver module socket cage (142) according to claim 1, **characterized in that** the optical transceiver module socket cage (142) further comprises two transfer tubes (1426a, 1426b), fixedly connected to the inlet (1424d) and the outlet (1424e) respectively.

14. The optical transceiver module socket cage (142) according to claim 13, **characterized in that** two grooves (1424j or 1424i) are formed on inner side walls of the outlet (1424e) or the inlet (1424d), the two grooves (1424j or 1424i) are arranged opposite to each other and extend in parallel, and the corresponding transfer tube (1426b or 1426a) tightly fits in the two grooves (1424j or 1424i).

15. The optical transceiver module socket cage (842) according to claim 1, **characterized in that** the cage body comprises a plurality of spring pieces (8422b), disposed in the first module-receiving slot (8422a) opposite to the liquid cooling component (8424).

16. An optical transceiver module (12), **characterized by** comprising:
a module housing (122), the module housing (122) having a length direction, the module housing (122) comprising a main housing (1222) and two vertical plates (1224), the main housing (1222) having a third flat heat-conducting surface (1222a), the two vertical plates (1224) protruding from the third flat heat-conducting surface (1222a), the two vertical plates (1224) extending parallel to the length direction and being located on opposite sides of the main housing (1222), a structure-less space (1226) being formed between the two vertical plates (1224) and the third flat heat-conducting surface (1222a); and
an edge connector (124), the edge connector (124) being exposed on a side of the module housing (122) in the length direction.

17. An optical transceiver module set (1), **characterized by** comprising:
an optical transceiver module socket (14), the optical transceiver module socket (14) comprising a connector socket (144) and the optical transceiver module socket cage (142) according to any of claims 1 to 15, the connector socket (144) being disposed in the first module-receiving slot (1422a); and
an optical transceiver module (12), the optical transceiver module (12) comprising a module housing (122) and an edge connector (124), the module housing (122) comprising a main housing (1222), the main housing (1222) having a third flat heat-conducting surface (1222a);
wherein the optical transceiver module (12) is inserted into the first module-receiving slot (1422a) such that the edge connector (124) is inserted into the connector socket (144) and the third flat heat-conducting surface (1222a) contacts the liquid cooling component (1424) in the first module-receiving slot (1422a).

18. The optical transceiver module set (1) according to claim 17, **characterized in that** the module housing (122) comprises two vertical plates (1224), the two vertical plates (1224) protrude from the third flat heat-conducting surface (1222a), the module housing (122) has a length direction, the two vertical plates (1224) extend parallel to the length direction and are located on opposite sides of the main housing (1222), a structure-less space (1226) is formed between the two vertical plates (1224) and the third flat heat-conducting surface (1222a), and the optical transceiver module (12) is inserted into the first module-receiving slot (1422a) such that the liquid cooling component (1424) enters the structure-less space (1426) between the two vertical plates (1424).

## Amended claims

### Amended claims in accordance with Rule 137(2) EPC.

1. An optical transceiver module socket cage (142), comprising:
a cage body (1422), the cage body (1422) forming a first module-receiving slot (1422a); and
a liquid cooling component (1424), the liquid cooling component (1424) having a flow channel structure (1424c) and an inlet (1424d) and an outlet (1424e) which are connected to the flow channel structure (1424c), the liquid cooling component (1424) being fixedly disposed in the cage body (1422) and being exposed in the first module-receiving slot (1422a), one of the liquid cooling component (1424) and the cage body (1422) comprising a sliding hook (1422d), the other of the liquid cooling component (1424) and the cage body (1422) comprising a first sliding slot (1424k), the liquid cooling component (1424) being fixed to the cage body (1422) by the sliding hook (1422d) sliding into and hooking the first sliding slot (1424k);
**characterized by** the sliding hook (1422d) sliding into the first sliding slot (1422k) in a sliding direction (D1), one of the liquid cooling component (1424) and the cage body (1422) comprising a stop spring piece (1422f), the other of the liquid cooling component (1424) and the cage body (1422) comprising a recess (1424n), and the stop spring piece (1422f) fitting in the recess (1424n) to prevent the liquid cooling component (1424) from sliding relative to the cage body (1422) in a direction opposite to the sliding direction (D1).

2. The optical transceiver module socket cage (142) according to claim 1, **characterized in that** the liquid cooling component (1424) has a first flat heat-conducting surface (1424p), and the first flat heat-conducting surface (1424p) is exposed in the first module-receiving slot (1422a).

3. The optical transceiver module socket cage (142) according to claim 1, **characterized in that** the first module-receiving slot (1422a) has a length direction (1422b), the flow channel structure (1424c) comprises a first flow channel portion (1424f) and a second flow channel portion (1424g), the first flow channel portion (1424f) and the second flow channel portion (1424g) extend parallel to the length direction (1422b), and the inlet (1424d), the first flow channel portion (1424f), the second flow channel portion (1424g), and the outlet (1424e) are connected in sequence.

4. The optical transceiver module socket cage (142) according to claim 3, **characterized in that** the first flow channel portion (1424f) or the second flow channel portion (1424g) comprises two sub-flow channels (1424h), and the two sub-flow channels (1424h) extend parallel to the length direction (1422b) and are connected in parallel.

5. The optical transceiver module socket cage (642) according to claim 3, **characterized in that** the cage body (6422) forms a second module-receiving slot (6423b), the first module-receiving slot (6423a) and the second module-receiving slot (6423b) are arranged in parallel and adjacent to each other, the liquid cooling component (6424) is also exposed in the second module-receiving slot (6423b), the flow channel structure (6424c) comprises a third flow channel portion (6424h) and a fourth flow channel portion (6424i), the first flow channel portion (6424f) and the second flow channel portion (6424g) correspond to the first module-receiving slot (6423a), the third flow channel portion (6424h) and the fourth flow channel portion (6424i) extend parallel to the length direction (6422b) and correspond to the second module-receiving slot (6423b), and the inlet (6424d), the first flow channel portion (6424f), the second flow channel portion (6424g), the third flow channel portion (6424h), the fourth flow channel portion (6424i), and the outlet (6424e) are connected in sequence.

6. The optical transceiver module socket cage (142) according to claim 1, **characterized in that** the first module-receiving slot (1422a) has a length direction (1422b) and has an insertion opening (1422c) in the length direction (1422b), and the inlet (1424d) and the outlet (1424e) are both located on a side of the liquid cooling component (1424) close to or away from the insertion opening (1422c) in the length direction (1422b).

7. The optical transceiver module socket cage (142) according to claim 6, **characterized in that** the cage body (1422) comprises the sliding hook (1422d), the liquid cooling component (1424) comprises the first sliding slot (1424k) and a second sliding slot (1424m), when the liquid cooling component (1424) is fixed to the cage body (1422) by the sliding hook (1422d) sliding into and hooking the first sliding slot (1424k), the inlet (1424d) and the outlet (1424e) are relatively close to the insertion opening (1422c), and when the liquid cooling component (1424) is fixed to the cage body (1422) by the sliding hook (1422d) sliding into and hooking the second sliding slot (1424m), the inlet (1424d) and the outlet (1424e) are relatively away from the insertion opening (1422c).

8. The optical transceiver module socket cage (142) according to claim 1, **characterized in that** the first module-receiving slot (1422a) has a length direction (1422b), and the inlet (1424d) and the outlet (1424e) are located on opposite sides of the liquid cooling component (1424) in a direction perpendicular to the length direction (1422b).

9. The optical transceiver module socket cage (742) according to claim 8, **characterized in that** the cage body (7422) forms a second module-receiving slot (6423b), the first module-receiving slot (6423a) and the second module-receiving slot (6423b) are arranged in parallel and adjacent to each other, the cage body (7422) has a separation wall (6422d'), the separation wall (6422d') is located between the first module-receiving slot (6423a) and the second module-receiving slot (6423b) and has a notch (6422f), the liquid cooling component (7424) comprises a first structural portion (6425a), a second structural portion (6425b), a structural connection portion (6425c), and a middle connection portion (6425f), the first structural portion (6425a) and the second structural portion (6425b) are separated from each other but are connected through the structural connection portion (6425c) and the middle connection portion (6425f), the structural connection portion (6425c) and the middle connection portion (6425f) are separated from each other, the first structural portion (6425a), the second structural portion (6425b), and the structural connection portion (6425c) together form the flow channel structure (6424c), the first structural portion (6425a) is exposed in the first module-receiving slot (6423a), the second structural portion (6425b) is exposed in the second module-receiving slot (6423b), and the middle connection portion (6425f) fits in the notch (6422f).

10. The optical transceiver module socket cage (142) according to claim 1, **characterized in that** the liquid cooling component (1424) comprises a base (1424a) and a top cover (1424b), the base (1424a) forms the flow channel structure (1424c), and the top cover (1424b) is fixed to the base (1424a) to cover the flow channel structure (1424c).

11. The optical transceiver module socket cage (142) according to claim 1, **characterized in that** the optical transceiver module socket cage (142) further comprises two transfer tubes (1426a,1426b), fixedly connected to the inlet (1424d) and the outlet (1424e) respectively.

12. The optical transceiver module socket cage (142) according to claim 11, **characterized in that** two grooves (1424j or 1424i) are formed on inner side walls of the outlet (1424e) or the inlet (1424d), the two grooves (1424j or 1424i) are arranged opposite to each other and extend in parallel, and the corresponding transfer tube (1426b or 1426a) tightly fits in the two grooves (1424j or 1424i).

13. The optical transceiver module socket cage (842) according to claim 1, **characterized in that** the cage body comprises a plurality of spring pieces (8422b), disposed in the first module-receiving slot (8422a) opposite to the liquid cooling component (8424).

14. An optical transceiver module (12), **characterized by** comprising:
a module housing (122), the module housing (122) having a length direction, the module housing (122) comprising a main housing (1222) and two vertical plates (1224), the main housing (1222) having a third flat heat-conducting surface (1222a), the two vertical plates (1224) protruding from the third flat heat-conducting surface (1222a), the two vertical plates (1224) extending parallel to the length direction and being located on opposite sides of the main housing (1222), a structure-less space (1226) being formed between the two vertical plates (1224) and the third flat heat-conducting surface (1222a); and
an edge connector (124), the edge connector (124) being exposed on a side of the module housing (122) in the length direction.

15. An optical transceiver module set (1), **characterized by** comprising:
an optical transceiver module socket (14), the optical transceiver module socket (14) comprising a connector socket (144) and the optical transceiver module socket cage (142) according to any of claims 1 to 13, the connector socket (144) being disposed in the first module-receiving slot (1422a); and
an optical transceiver module (12), the optical transceiver module (12) comprising a module housing (122) and an edge connector (124), the module housing (122) comprising a main housing (1222), the main housing (1222) having a third flat heat-conducting surface (1222a);
wherein the optical transceiver module (12) is inserted into the first module-receiving slot (1422a) such that the edge connector (124) is inserted into the connector socket (144) and the third flat heat-conducting surface (1222a) contacts the liquid cooling component (1424) in the first module-receiving slot (1422a).

16. The optical transceiver module set (1) according to claim 15, **characterized in that** the module housing (122) comprises two vertical plates (1224), the two vertical plates (1224) protrude from the third flat heat-conducting surface (1222a), the module housing (122) has a length direction, the two vertical plates (1224) extend parallel to the length direction and are located on opposite sides of the main housing (1222), a structure-less space (1226) is formed between the two vertical plates (1224) and the third flat heat-conducting surface (1222a), and the optical transceiver module (12) is inserted into the first module-receiving slot (1422a) such that the liquid cooling component (1424) enters the structure-less space (1426) between the two vertical plates (1424).
